# EUROPEAN PATENT APPLICATION

(11) **EP 4 770 296 A1**
(43) Date of publication of application: **01.07.2026**
(21) Application number: 25223697.1
(22) Date of filing: 16.12.2025
(51) Int. Cl.: H05K 7/20

(54) **RACK CABINET FOR ELECTRONIC DEVICES**

(30) Priority: 24.12.2024 IT 202400029973
(71) Applicant: Cybertechno Group S.r.l., 80121 Napoli NA (IT)
(72) Inventor: Iaquinto, Andrea, 80010 Quarto NA (IT); Avella, Giulio, 80126 Napoli NA (IT); Cozzolino, Marcello, 80121 Napoli NA (IT)
(74) Representative: Perani & Partners S.p.A.

(57) **Abstract**

A rack cabinet (1) for electronic devices comprises a compartment (2) defining a cavity (2b) delimited by heat-insulating walls (2a), a support (3) for electronic devices, housed in the compartment (2) and extending at least between two opposite side walls, and a refrigeration cycle cooling apparatus (4) housed in a chamber separate from the cavity (2b) and in fluid communication with it to cool a volume of air inside it. The cooling apparatus (4) and the compartment (2) are operatively associated with each other to define a closed and isolated fluid-dynamic circuit for cooling said volume of air. The rack cabinet (1) also comprises a first temperature detecting element (5) to detect a target temperature inside the cavity (2b) and generate a temperature signal, and a control unit (6) configured to act on the cooling apparatus (4) as a function of the generated signal to change the temperature of the air volume.

## Description

### Technical Field

The present invention relates to a rack cabinet comprising an integrated cooling apparatus and a respective method of use thereof. Such a rack cabinet finds useful application in the SmallOffice-HomeOffice but also in the industrial field, with particular application in the management of hardware components, including servers, switches and routers.

### Description of the Prior Art

In the state of the art, there is a strongly felt need to maintain a rack cabinet in stable and optimal temperature conditions, such that it is possible to prevent the overheating of electronic devices arranged in said rack cabinet. To maintain the aforementioned temperature conditions, various solutions have been developed in the state of the art.

The most frequently adopted solution, of simple implementation, is to place one or more rack cabinets inside an air-conditioned room, for example a room in a building, in which it is therefore possible to set a specific ambient temperature.

However, this solution involves high energy and economic expenditure due to the need to cool the entire room, which is typically poorly insulated with respect to the rest of the building.

For this reason, solutions have been provided in the known art that are capable of providing targeted cooling, in which the rack cabinet is integrated into a complex system comprising at least one cooling device or apparatus.

An example of such a system is shown in document CN207589314 U, which describes a rack cabinet comprising an inner compartment, in turn arranged inside an outer compartment. The inner compartment is placed in fluid communication with the environment external to the system through an opening provided with a filter suitable for preventing the entry of dust or other particles. The outer compartment comprises a cooling apparatus placed below the inner compartment of the rack cabinet, configured to condition the temperature inside the cavity formed between the inner compartment and the outer compartment.

Further examples of rack cabinets equipped with cooling apparatuses are shown in documents JP 2015005677 A and US 2017/280593 A1. In both described solutions, the cooling apparatus is structurally integrated into the rack cabinet, making the inner compartment, intended to house the electronic components, an integral part of the cooling apparatus itself.

### Problem of the prior art

The main solutions known from the prior art require the cooling of rooms or systems of significantly larger dimensions than the rack cabinet, thus involving significant energy and consequent economic expenditure.

In particular, due to a generalized cooling of the environment surrounding the rack cabinet, whether it is the room or an outer compartment of the rack cabinet, a poor cooling efficiency is associated with the known systems.

The solutions that instead provide for an integrated cooling apparatus present major limitations in maintenance and repair operations. Indeed, in case of failure or malfunction of the cooling apparatus, it is not possible to intervene on the single component independently, but it is necessary to replace or disassemble the entire rack cabinet. This entails high costs, long infrastructure downtime and poor operational flexibility during maintenance and repair activities.

### Summary of the invention

In this context, the technical task underlying the present invention is to provide a rack cabinet and a related method of use thereof capable of overcoming the limitations of the prior art.

In particular, it is a purpose of the present invention to provide a rack cabinet capable of maximizing cooling efficiency by limiting the necessary energy input and the costs associated with said cabinet.

A further purpose of the present invention is to provide a rack cabinet capable of facilitating maintenance and repair interventions.

A further purpose of the present invention is to prevent localized temperature increases in the internal environment of the rack cabinet that could cause malfunctions or damage to one or more electronic devices arranged therein.

The stated technical task and the specified purposes are substantially achieved by a rack cabinet and a related method of use thereof in accordance with one or more of the appended claims.

### Advantages of the invention

The rack cabinet of the present invention allows for maximizing the cooling efficiency of the environment surrounding the electronic devices arranged in said rack cabinet, resulting in significant energy and economic savings.

In particular, the present rack cabinet provides for directly cooling its internal environment, thermally insulating it and preventing air exchanges with the external environment, in such a way as to optimize the maintenance of a specific temperature inside the rack cabinet itself.

Advantageously, thanks to its effective and simple structure, the rack cabinet of the present invention allows for simplifying its logistical management, providing greater flexibility in the choice of installation environment and surrounding conditions.

A particular advantage of the present rack cabinet is that it is scalable according to the needs of use. In more detail, said rack cabinet can be used both in an industrial environment and in small-sized contexts, for example small offices or home offices, thanks to the considerable reduction in operating costs compared to known solutions, as a result of a targeted cooling of its internal environment.

A further advantage, particularly relevant in the sector, is the possibility of easily accessing the cooling apparatus of the rack cabinet, allowing maintenance or repair activities to be carried out exclusively on it, without the need to replace the entire rack cabinet. Indeed, the positioning and compactness of the apparatus allow for intervening in an effective and targeted manner.

This allows for ensuring continuous operation (business continuity), avoiding infrastructure downtime.

Thanks to an embodiment, the rack cabinet provides for recirculating the air inside the rack cabinet itself, in such a way as to make the temperature of the air volume inside the rack cabinet uniform and prevent localized temperature increases due, for example, to the overheating of one or more electronic devices arranged therein.

### BRIEF DESCRIPTION OF THE DRAWINGS

Further characteristics and advantages of the present invention will become clearer from the indicative, and therefore non-limiting, description of a preferred but not exclusive embodiment of a rack cabinet, shown by way of example in the set of drawings in which:
- Figure 1 schematically shows a rack cabinet according to the present invention;

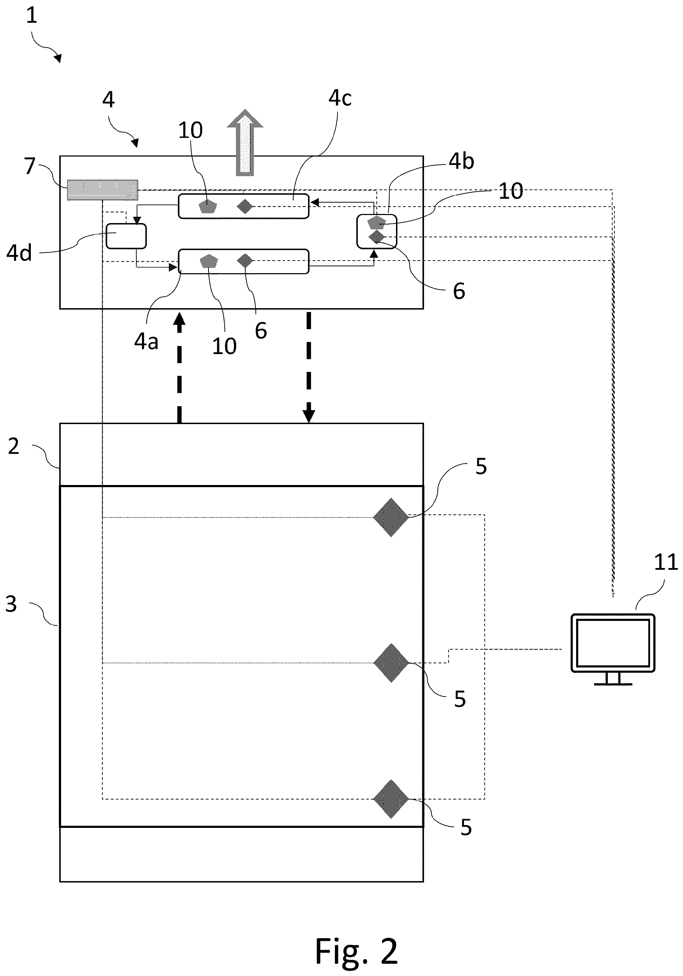

- Figure 2 shows a block diagram of the rack cabinet according to the present invention.

### DETAILED DESCRIPTION

With reference to the attached figures, the number 1 indicates a rack cabinet for electronic devices, the subject of the present invention.

Said rack cabinet 1 comprises a compartment 2 having a plurality of walls 2a and defining a cavity 2b delimited at least in part by said walls 2a. The cavity 2b is therefore internal to said walls 2a.

Preferably, the plurality of walls 2a comprises a plurality of side walls, a top wall and a bottom wall. It should be noted, however, that the number, surface and type (planar, concave, convex, etc.) of walls can vary depending on the structure and space requirements.

One or more walls 2a of the compartment 2 are made at least in part of heat-insulating material, in such a way as to ensure more efficient maintenance of the air temperature inside the compartment 2, as better detailed in the remainder of the present description. In detail, at least the side walls, and preferably also the top wall and/or the bottom wall, are made at least in part of heat-insulating material.

The rack cabinet 1 also comprises a support 3, housed internally to the compartment 2, configured to receive and support one or more electronic devices 30. By way of example, the electronic devices can comprise servers, switches, routers or any other electronic appliance. It should be noted that, as is known in the technical field, the support 3 can support, in addition to electronic devices, also passive devices, such as patch panels, cable organizers or other network infrastructures.

The support 3, in one embodiment, comprises a DIN type rail compatible with the dimensions of the electronic devices 30.

The support 3 can also be embodied, in addition or as an alternative to the DIN rail, in a plurality of shelves, or racks, spaced apart from each other in height inside the compartment 2.

According to a preferred aspect, the rear wall of the compartment 2 has one or more openings for the passage of cables (not shown). Said openings preferably comprise one or more sealing elements configured to prevent the exchange of air and/or heat with the environment external to the compartment 2. Still preferably, the openings are arranged according to an ordered and organized geometry, in such a way as to reduce the bulk of the cables of the electronic devices.

According to a preferred aspect, the rack cabinet 1 comprises an access door in correspondence with a side wall 2a, for example the front wall opposite said rear wall. Said access door can be opened and closed by a user and/or manually or automatically.

Preferably, said access door comprises a portion made of tempered glass and/or one or more heat-insulating panels. In this way, it is possible to minimize the heat exchange with the environment external to the compartment 2.

The rack cabinet 1 also comprises a refrigeration cycle cooling apparatus 4, placed in fluid communication with the cavity 2b of the compartment 2. Preferably, the cooling apparatus 4, or a part thereof, is arranged in correspondence with a top wall of the compartment 2. Still preferably, the cooling apparatus 4 is arranged externally to the compartment 2.

Alternatively, the cooling apparatus 4 is arranged at least in part, for example at least one of its components, inside the compartment 2.

According to the preferred aspect, the cooling apparatus 4, or a part thereof, is arranged in a volume, or chamber, separate from the volume in which the support 3 is inserted. In more detail, the cooling apparatus 4 is arranged in a first chamber, while the support 3 is arranged in a second chamber, defining the cavity 2b, separated from the first chamber, for example by means of a dividing septum.

The cooling apparatus 4 is therefore preferably enclosed in a single chamber placed above the second chamber in which the support 3 is contained. The first chamber is therefore compact and can be arranged inside or outside the compartment 2.

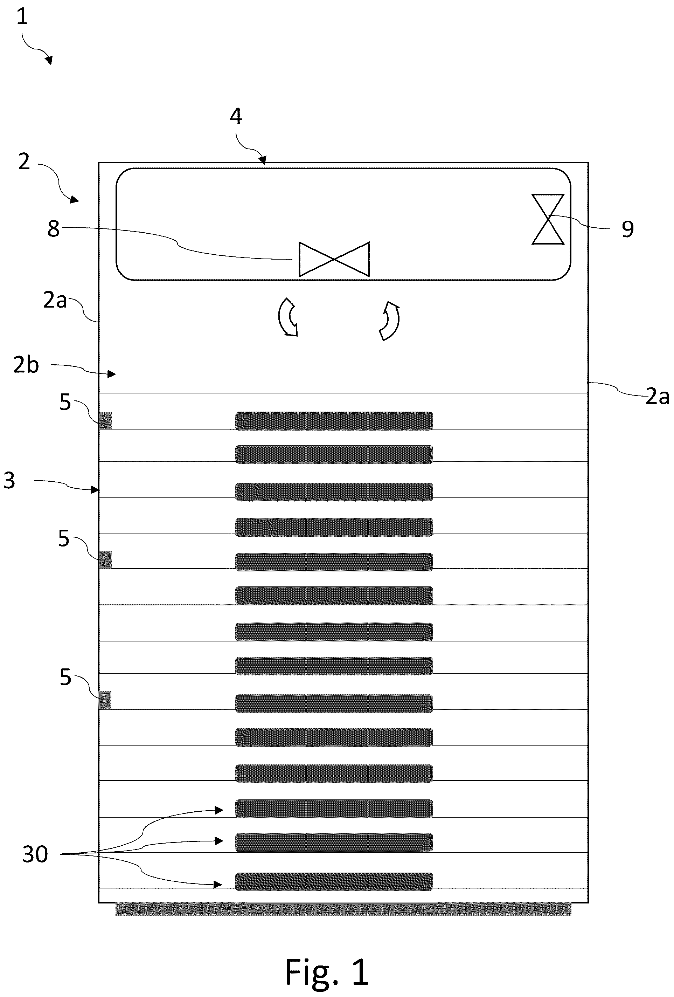

In more detail, as shown in figure 1, the second chamber has an upper end portion and a lower end portion, and the first chamber is arranged in correspondence with the upper end portion of the second chamber.

It should be noted that, although the two chambers are separate from each other, they are placed in fluid communication to allow the cooling apparatus 4 to cool the air volume inside the cavity 2b.

It is worth noting that this configuration allows for easy access to the cooling apparatus 4, allowing for its direct maintenance and/or allowing repair activities to be carried out exclusively on it, without the need to replace the entire rack cabinet 1. In this way, the cooling apparatus 4 can be removed and replaced for the necessary repair operations, ensuring the continuous operation of the rack cabinet 1 without downtime.

The cooling apparatus 4 is configured to cool a volume of air inside the cavity 2b. In more detail, the cooling apparatus 4 can be operated upon the occurrence of certain temperature conditions, as better detailed in the remainder of the present description, in order to keep the temperature of the air volume inside the chamber 2b constant and/or within a specific interval of optimal temperature values.

The rack cabinet 1 also comprises at least a first temperature detecting element 5 and preferably a plurality of first temperature detecting elements 5.

Each first temperature detecting element 5 is configured to detect a target temperature inside the cavity 2b and generate a respective temperature signal.

It should be noted that the target temperature can comprise the temperature of the air volume inside the cavity 2b, or the temperature of one or more electronic devices housed on the support 3. It should be noted that, in the latter case, said target temperature has a direct influence on the temperature of the air volume inside the cavity 2b.

According to the preferred aspect, the first temperature detecting elements 5 comprise a respective temperature sensor, preferably located inside the compartment, for example on a wall 2a of the compartment 2 or on an electronic device.

Alternatively, the first temperature detecting elements 5 can comprise thermal cameras inserted inside the compartment 2 or, alternatively, integrated into a wall 2a of the compartment 2.

In accordance with a preferred embodiment, the rack cabinet 1 comprises two or more temperature sensors, preferably three temperature sensors, located at different heights inside the compartment 2, to detect the temperature of the air volume inside the cavity 2b in different positions.

In the remainder of the present description, where possible, to simplify the reading, reference will be made generically to a single first temperature detecting element 5. However, the technical characteristics described below for the single first temperature detecting element 5 are to be understood as present for each of the first temperature detecting elements present.

The rack cabinet 1 also comprises a control unit 7 placed in signal communication with the cooling apparatus 4 and with the first temperature detecting element 5.

The control unit 7 is configured to act on the cooling apparatus 4, for example by operating it, switching it off or modifying its operation, as a function of the value of the signal generated by the first temperature detecting element 5, in order to change the temperature of the air volume inside the cavity 2b.

It should be noted that the control unit 7 is preferably configured to process the signal generated by each first temperature detecting element 5, and/or to combine it with one or more signals generated by the other first temperature detecting elements 5.

The control unit 7 is therefore configured to act on the cooling apparatus 4 as a function of a single signal, the combination of two or more signals or a processing thereof.

It should be noted, in fact, that if the target temperature is associated with a respective electronic device, it will have a limited impact on the temperature of the air volume inside the cavity 2b, and therefore a different influence on the operation of the cooling apparatus 4 with respect to the temperature of the air volume inside the cavity 2b.

According to one aspect, the control unit 7 is configured to dynamically control the cooling apparatus 4 as a function of the signals generated by the first temperature detecting elements 5. In more detail, the control unit 7 is configured to receive as input information related to the positioning of the electronic devices on the support 3 and to consequently adapt the operation of the cooling apparatus 4 as a function of the position of each electronic device, taking into account the local impact of each device on the temperature. This information can be acquired, for example, through an input from the user, or by means of local temperature detection at different heights, associating each electronic device with its relative energy consumption and heat dissipation.

According to the preferred embodiment of the invention, the control unit 7 is integrated into the cooling apparatus 4. Alternatively, the control unit 7 is inserted internally to the compartment or placed externally to it.

The cooling apparatus 4 and the compartment 2 are operatively associated with each other to define a closed fluid-dynamic circuit for cooling the air volume inside the cavity 2b, i.e., a fluid-dynamically isolated circuit with respect to the external environment.

In other words, inside the compartment 2, under normal operating conditions, i.e., in conditions where the access door is closed, there is no ingress or egress of air except for a direct air exchange with the cooling apparatus 4 or with a part thereof. In detail, the compartment 2 itself is fluid-dynamically isolated from the environment external to the compartment 2.

Consequently, it is worth noting that the exchange of air with the environment external to the compartment 2 can only occur upon the opening of the access door of the rack cabinet 1.

It is worth noting that the rack cabinet 1 of the present description allows for effectively maintaining the temperature of the air volume inside the cavity 2b at (or around) a desired value or within a predetermined interval of optimal values.

Advantageously, in fact, the fluid-dynamic isolation of the compartment 2 with respect to its external environment allows for maximizing the cooling efficiency of the environment internal to the cavity 2a, that is, the environment immediately external to the electronic devices arranged in the rack cabinet 1. Indeed, the heat exchange with the external environment is minimized, thus allowing for adequate temperature control.

In accordance with a preferred embodiment of the invention, the cooling apparatus 4 comprises at least one recirculation fan 8 configured to move the air volume directly in the cavity 2b of the compartment 2 in order to keep the temperature of the air volume inside the cavity 2b uniform.

It is worth noting that the recirculation of air inside the compartment 2 prevents the occurrence of localized temperature increases, for example following the overheating of one or more electronic devices located on the support 3.

According to the preferred embodiment, the recirculation fan 8 is configured to operate in at least a first use configuration independently of the target temperature detected inside the cavity 2b. In other words, unless there are different use conditions, the recirculation fan 8 is configured to operate continuously regardless of the target temperature and/or the temperature of the air volume inside the cavity 2b.

Still according to the aforementioned embodiment, the recirculation fan 8 is configured to operate in one or more further use configurations, alternative to the first configuration, each associated with a respective operating speed of the recirculation fan 8 as a function of the target temperature detected inside the cavity 2b.

In more detail, upon exceeding a limit value of the target temperature detected by the first temperature detecting element 5, the control unit 7 is configured to operate the recirculation fan 8 in a respective use configuration. As a function of the value of the signal generated following the detected target temperature value, the control unit 7 is configured to select the most suitable use configuration. Upon reaching an optimal temperature value, the control unit 7 is configured to bring the recirculation fan 8 into the first configuration.

By way of example, the recirculation fan 8 has three or more different operating speeds, preferably six operating speeds, depending on the target temperature or the temperature of the air inside the cavity 2b.

As previously anticipated, in order to maximize the efficiency of maintaining a constant temperature inside the cavity 2b, the walls of the compartment 2 are heat-insulating, i.e., made at least in part of heat-insulating material.

In particular, according to the preferred embodiment of the invention, each wall 2a of the compartment 2 comprises an inner layer having a first surface which can be facing the cavity 2b of the compartment 2 and an opposite second surface which can be facing an environment external to the compartment 2. The inner layer of the walls 2a is made of heat-insulating polymeric material, preferably high-density expanded polyurethane.

Advantageously, expanded polyurethane has excellent insulating properties and is capable of minimizing thermal dispersion.

According to the same embodiment, each wall 2a also comprises a pair of coating layers arranged respectively on the first surface and on the second surface of the inner layer. In other words, each wall is made according to a so-called "sandwich" arrangement, with an inner coating layer, facing the cavity 2b, the inner layer, and an outer coating layer, facing the environment external to the compartment 2.

Preferably, the coating layers are made of metallic material, more preferably aluminium. Advantageously, the coating layers of metallic material allow for providing adequate mechanical properties and high resistance to corrosion.

It is worth noting that the walls 2a thus made allow for effectively insulating the internal environment of the compartment 2 even in conditions of considerably high external temperature.

According to the preferred embodiment of the invention, the cooling apparatus 4 comprises a plurality of devices, comprising at least an evaporator device 4a, a compressor device 4b, a condenser device 4c and an expander device 4d.

In more detail, the evaporator device 4a is placed in fluid communication with the compartment 2, and in particular with the cavity 2b. The evaporator device 4a defines with the compartment 2 the closed fluid-dynamic circuit for cooling the air volume inside the cavity 2b.

Preferably, at least the evaporator device 4a is arranged in correspondence with the top wall of the compartment 2. Still preferably, the evaporator device 4a is arranged externally to the compartment 2. Alternatively, the evaporator device 4a is arranged inside the compartment 2. As anticipated above, according to the latter embodiment, the evaporator device 4a is arranged in a chamber distinct from the chamber defining the cavity 2b, although they are placed in fluid communication with each other.

In particular, the evaporator device 4a is configured to exchange heat with the air volume inside the cavity 2b through a working fluid. In more detail, the evaporator device 4a comprises the recirculation valve 8 suitable for allowing the movement of the air volume and the exchange of heat with the working fluid. Preferably, the working fluid is a refrigerant fluid, preferably based on a hydrocarbon, for example propane.

Still preferably, the evaporator device 4a is configured to operate at a temperature comprised in a predetermined working interval, which is associated with a dew point beyond a respective threshold. Said working interval is defined, for example, between 25 °C and 30 °C. It should be noted, in fact, that a high dew point allows for obtaining effective cooling of the air inside the compartment 2 and effective dehumidification thereof. Advantageously, therefore, the evaporator device 4 can be associated with an optimal dew point such that it is possible to avoid the formation of humidity and, therefore, of condensation inside the rack cabinet 1.

According to this embodiment, the compressor device 4b is placed in fluid communication with the evaporator device 4a and is suitable for receiving the working fluid in a gaseous state, i.e., evaporated, from the evaporator device 4a. The compressor device 4b is configured to compress the evaporated working fluid, increasing its pressure and temperature.

Still according to this embodiment, the condenser device 4c is placed in fluid communication with the compressor device 4b and is configured to receive the working fluid at an increased pressure and temperature. The condenser device 4c is configured to condense the evaporated working fluid, returning it to the liquid state. The condenser device 4c, during this operation, is also configured to exchange heat with an environment external to the cooling apparatus 4 through the working fluid.

According to a preferred aspect, the cooling apparatus 4, and more preferably the condenser device 4c, comprises a cooling fan 9 configured to be operated upon reaching a temperature detected externally to the cooling apparatus 4, and in particular at the condenser device 4c, which is higher than a certain threshold temperature. Preferably, said threshold temperature is set between 26 °C and 32 °C, more preferably at 28 °C.

According to this embodiment, the expander device 4d is placed in fluid communication with the condenser device 4c and is configured to receive the working fluid from the condenser device 4c. The expander device 4d is also configured to cool the working fluid and decrease the pressure of said working fluid. Preferably, the expander device 4d is of the capillary tube type. It should be noted that said expander device 4d is also in fluid communication with the evaporator device 4a.

It should be noted that the constituent elements of a refrigeration cycle cooling apparatus 4 are known in the technical field and, therefore, will not be further described.

According to a preferred embodiment of the invention, the rack cabinet 1 comprises at least one second temperature detecting element 6, preferably a temperature sensor, associated with at least one device of the cooling apparatus 4 and configured to detect the temperature of the respective device.

Preferably, the rack cabinet 1 comprises a plurality of second temperature detecting elements 6, and more preferably a respective second temperature detecting element at least for the evaporator device 4a, the compressor device 4b, and the condenser device 4c.

Optionally, the first and second temperature detecting elements 5, 6 can be placed in signal communication with a control device, for example a thermostat, placed externally to the compartment 2, in such a way as to allow a rapid check of the temperatures detected by said temperature detecting elements by the user.

According to an embodiment, the rack cabinet 1 comprises one or more power supply voltage control elements 10.

Preferably, each power supply voltage control element 10 is placed in signal communication with a respective first or second temperature detecting element 5, 6.

According to a preferred aspect, at least one power supply voltage control element 10 associated with a device of the cooling apparatus 4, and preferably each power supply voltage control element 10 associated with a device of the cooling apparatus 4, is configured to interrupt the electric power supply of the relative device to which it is associated when a limit temperature is reached, which is detected by the first and/or second temperature detecting element 5, 6.

According to the same aspect, a respective power supply voltage control element 10 is associated with each component of the cooling apparatus 4, devices, fans or parts thereof. In this way, it is possible to control the power supply of each component to interrupt it, for example, in emergency situations.

The power supply voltage control elements 10 preferably comprise a relay. Still preferably, said power supply voltage control elements 10 can be activated automatically, without external intervention by the user, and/or remotely.

According to an embodiment, the rack cabinet 1 comprises a remote management unit 11 which can be commanded by a user.

The remote management unit 11 is preferably placed in signal communication with the control unit 7.

Still preferably, the remote management unit 11 is placed in signal communication with the cooling apparatus 4.

According to one aspect, the remote management unit 11 is configured to act on the control unit 7 and/or directly on the cooling apparatus 4 to change the target temperature and/or the temperature of the air volume inside the cavity 2b of the compartment 2.

Still preferably, the remote management unit 11 is placed in signal communication with the first and/or the second temperature detecting element 5, 6.

Still preferably, the remote management unit 11 is placed in signal communication with one or more power supply voltage control elements 10.

According to the same aspect, the remote management unit 11 is configured to act on the control unit 7 and/or directly on the cooling apparatus 4 and/or on one or more power supply voltage control elements 10 to switch on, switch off or interrupt the power supply of the cooling apparatus 4 or one of its devices, and/or of the control unit 7, for example in emergency conditions.

It is worth noting that the power supply of devices that are not placed in signal communication with the remote management unit 11, for example passive devices and/or devices not classified as smart devices, can be controlled automatically upon reaching critical conditions through the relays mentioned above. Smart devices, on the other hand, i.e., devices equipped with their own control unit and/or connected to the control unit 7 of the present rack cabinet 1, can be commanded through said remote management unit 11.

It should be noted that the remote management unit 11 is preferably placed in signal communication also with one or more electronic devices arranged on the support 3. Furthermore, the remote management unit 11 is also configured to command and control the power supply of said devices.

Advantageously, the rack cabinet 1 of the present invention allows for controlling each component of the cabinet 1 in a selective and immediate manner, thus increasing the safety and functionality of the rack cabinet 1.

It is worth noting that a rack cabinet 1 according to the present invention, in the case of a small office, allows for reducing the overall energy consumption necessary for cooling the air volume inside the compartment 2.

Based on tests performed, the consumption of a rack cabinet 1 is limited, by way of example, to a maximum of 4 kW per 1440 minutes of continuous operation, thus obtaining a considerably reduced economic consumption, not exceeding 2 euros for 24 hours of continuous operation.

Thanks to this reduced consumption, it is also possible to place the rack cabinet 1 under a "substitute electrical power supply" or UPS. In particular, it is possible to electrically power, in case of temporary power outages, not only the electronic devices 30 contained in the rack 1, but also the cooling apparatus 4. This advantageously allows for ensuring the controlled operation/shutdown of the electronic devices 30.

A further object of the present invention is a method for managing a rack cabinet 1 according to the present description.

The method comprises the step of acquiring the target temperature inside the cavity 2b of the compartment 2 by means of the at least one first temperature detecting element 5. Preferably, said step provides for acquiring one or more target temperatures in different positions inside the compartment 2 by means of two or more first temperature detecting elements 5.

It should be noted that the acquisition of the target temperature occurs by means of the control unit 7, which receives the temperature signal generated by the one or more first temperature detecting elements 5.

Optionally, the method provides for processing and/or combining the signals generated by the first temperature detecting elements 5.

The method therefore comprises the step of comparing the acquired target temperature with a respective threshold temperature. Said threshold temperature is defined in an optimal temperature interval for the operation of the electronic devices arranged on the support 3.

According to the preferred embodiment, in which the rack cabinet 1 comprises the recirculation fan 8, before the step of acquiring the temperature, the method comprises the step of operating the recirculation fan 8 in the first use configuration. It should be noted indeed that the recirculation fan 8 in said first configuration operates independently of the detected target temperature.

Said first configuration will be maintained until different internal temperature conditions of the cavity 2b occur, as detailed below.

Upon exceeding the threshold temperature, the method comprises the step of operating the cooling apparatus 4 by means of the control unit 7 to change the temperature of the air volume inside the cavity 2b. In more detail, the cooling apparatus 4, and in particular the evaporator device 4a, absorbs heat directly from the cavity 2b to cool the air volume inside the cavity 2b.

According to the preferred embodiment, the step of operating the cooling apparatus 4 provides for operating the recirculation fan 8 in a use configuration different from the first configuration at a respective operating speed as a function of the target temperature detected by the first temperature detecting element 5.

In more detail, said step provides for selecting the optimal use configuration as a function of the value of the signal generated by the first temperature detecting element 5.

In this way, for high target temperature values, it is possible to select the optimal use configuration that allows for reducing the target temperature in the shortest possible time.

According to the preferred aspect, the step of operating the cooling apparatus 4 provides for acquiring an external temperature to the cooling apparatus 4 by means of a second temperature detecting element 6.

Said step also provides for comparing the detected external temperature with a threshold temperature, for example 28°C.

The aforementioned step therefore provides, for external temperatures equal to or greater than the threshold temperature, for operating the cooling fan 9. It should be noted that for external temperatures lower than said threshold temperature, the cooling fan 9 is not activated. In this way, it is possible to optimize the efficiency of the cooling apparatus 4.

## Claims

1. Rack cabinet (1) for electronic devices, comprising:
- a compartment (2) comprising a plurality of walls (2a) and defining a cavity (2b) delimited by said walls (2a),
- a support (3) configured to receive and support one or more electronic devices, the support (3) being housed internally to the compartment (2),
- a refrigeration cycle cooling apparatus (4) placed in fluid communication with the cavity (2b) of the compartment (2) and configured to cool a volume of air inside the cavity (2b);
- at least a first temperature detecting element (5) configured to detect a target temperature inside the cavity (2b) and generate a respective temperature signal;
- a control unit (7) placed in signal communication with the cooling apparatus (4) and with the first temperature detecting element (5) and configured to act on the cooling apparatus (4) as a function of the value of the signal generated by the first temperature detecting element (5) to change the temperature of the air volume inside the cavity (2b);
**characterized in that**
- one or more walls (2a) of the compartment (2) are made at least in part of heat-insulating material;
- the cooling apparatus (4) is at least partially arranged in a first chamber, the support (3) being arranged in a second chamber defining the cavity (2b), separated from the first chamber and placed in fluid communication with the first chamber, the first chamber being arranged in correspondence with an upper end portion of the second chamber;
- the cooling apparatus (4) and the compartment (2) are operatively associated with each other to define a closed, fluid-dynamically isolated fluid-dynamic circuit from the external environment, for cooling the air volume inside the cavity (2b).

2. Rack cabinet (1) according to claim 1, wherein the cooling apparatus (4) comprises at least one recirculation fan (8) configured to move the air volume directly in the cavity (2b) of the compartment (2) to keep the temperature of the air volume inside the cavity (2b) uniform.

3. Rack cabinet (1) according to claim 2, wherein:
- the recirculation fan (8) is configured to operate in a first use configuration independent of the target temperature detected inside the cavity (2b), or
- the recirculation fan (8) is configured to operate in one or more use configurations alternative to the first configuration as a function of the target temperature detected inside the cavity (2b), each associated with a respective operating speed of the recirculation fan.

4. Rack cabinet (1) according to any one of claims 1 to 3, wherein each wall of the compartment (2) comprises:
- an inner layer having a first surface which can be facing the cavity (2b) of the compartment (2) and an opposite second surface which can be facing an environment outside the compartment (2), the inner layer being made of heat-insulating polymeric material,
- a pair of coating layers arranged respectively on the first surface and on the second surface of the inner layer, the coating layers being preferably made of metallic material.

5. Rack cabinet (1) according to any one of claims 1 to 4, wherein the cooling apparatus (4) comprises a cooling fan (9) configured to be operated upon reaching a temperature outside the cooling apparatus (4) detected by a respective temperature detecting element that is higher than a certain threshold temperature.

6. Rack cabinet (1) according to any one of claims 1 to 5, wherein the cooling apparatus (4) comprises a plurality of devices, comprising at least:
- an evaporator device (4a) placed in fluid communication with the compartment (2) and configured to exchange heat with the air volume inside the cavity (2b) through a working fluid, the evaporator device (4a) defining with the compartment (2) the closed fluid-dynamic circuit for cooling the air volume inside the cavity (2b);
- a compressor device (4b) placed in fluid communication with the evaporator device (4a) and configured to compress the working fluid;
- a condenser device (4c) placed in fluid communication with the compressor device (4b) and configured to receive the compressed working fluid and exchange heat with an external environment by means of the compressed working fluid;
- an expander device (4d) placed in fluid communication with the condenser device (4c) and configured to expand the compressed working fluid and cool said working fluid.

7. Rack cabinet (1) according to claim 6, wherein the evaporator device (4a) of the cooling apparatus (4) is configured to operate at a temperature comprised in a predetermined working interval, said working interval being associated with a dew point that is beyond a respective threshold.

8. Rack cabinet (1) according to claim 6 or 7, comprising at least one second temperature detecting element (6) associated with at least one device of the cooling apparatus (4) and configured to detect the temperature of the respective device.

9. Rack cabinet (1) according to claim 8, comprising one or more power supply voltage control elements (10), each placed in signal communication with a respective second temperature detecting element (6), wherein at least one power supply voltage control element (10) is configured to interrupt the electric power supply of a respective device of the cooling apparatus (4) upon reaching a limit temperature detected by the respective second temperature detecting element (6).

10. Rack cabinet (1) according to any one of claims 1 to 9, comprising a remote management unit (11) which can be commanded by a user and placed in signal communication with:
- the control unit (7) and/or with the cooling apparatus (4);
- the first and/or the second temperature detecting element (5, 6), wherein the remote management unit (11) is configured to:
- act on the control unit (7) and/or on the cooling apparatus (4) to change the temperature of the air volume inside the cavity (2b) of the compartment (2) and/or
- control and command the power supply of the control unit (7) and/or of the cooling apparatus (4).

11. Method for managing a rack cabinet (1) according to any one of claims 1 to 10, comprising the steps of:
- acquiring the target temperature inside the cavity (2b) of the compartment (2) by means of the at least one first temperature detecting element (5);
- comparing the acquired target temperature with a threshold temperature;
- upon exceeding the threshold temperature, operating the cooling apparatus (4) by means of the control unit (7) to change the temperature of the air volume inside the cavity (2b), the cooling apparatus (4) absorbing heat directly from the cavity (2b) to cool the air volume inside the cavity (2b).
